# EUROPEAN PATENT APPLICATION

(11) **EP 3 825 709 A1**
(43) Date of publication of application: **26.05.2021**
(21) Application number: 19211143.3
(22) Date of filing: 25.11.2019
(51) Int. Cl.: G01R 33/28, G01R 33/567

(54) **MAGNETIC RESONANCE EXAMINATION SYSTEM WITH CARRIER**

(71) Applicant: Koninklijke Philips N.V., 5656 AG Eindhoven (NL)
(72) Inventor: LEUSSLER, Christoph, 5656 AE EINDHOVEN (NL); WIRTZ, Daniel, 5656 AE Eindhoven (NL)
(74) Representative: Philips Intellectual Property & Standards

(57) **Abstract**

For a magnetic resonance examination system (1), a solution for proper positioning of auxiliary equipment (8) inside a bore (3) of a magnet (2) of a magnetic resonance examination system (1) when in use, and outside of the bore (3) of the magnet (2) and therefore outside of the examination zone (4) when idle shall be created. This is achieved by at least one carrier (7) for transporting auxiliary equipment (8), the carrier (7) mounted movable within the magnet (2) parallel to the center axis (16) of the magnet (2), for freely moving the auxiliary equipment (8) into the examination zone (4) and the carrier (7) being arranged to be moved outside of the bore (3) of the magnet (2), for freely moving the auxiliary equipment (8) out of the bore (3) of the magnet (2), the carrier (7) further being arranged such to position the auxiliary equipment (8) mounted to the carrier (7) in the examination zone (4) when the auxiliary equipment (8) is needed and to position the auxiliary equipment (8) mounted to the carrier (7) outside of the examination zone (4) when the auxiliary equipment (8) is not needed. The present invention also refers to a method for operating a magnetic resonance examination (1) system, to a non-transitory computer-readable medium for controlling a magnetic resonance examination system (1) and to a non-transitory computer-readable medium for upgrading a magnetic resonance imaging system (1).

## Description

### FIELD OF THE INVENTION

The invention relates to the field of a magnetic resonance examination system, in particular to a magnetic resonance examination system comprising a carrier for transporting auxiliary equipment out of the bore of a magnet, to a method for operating a magnetic resonance examination system, to a non-transitory computer-readable medium for controlling a magnetic resonance examination system and to a non-transitory computer-readable medium for upgrading a magnetic resonance imaging system.

### BACKGROUND OF THE INVENTION

Magnetic resonance examination systems scan a patient to provide detailed images of afflicted areas to aid healthcare providers in their diagnosis of ailments that may be present in the patient. Magnetic resonance examination systems utilize powerful magnetic fields to align protons within the body of a patient. Radio frequency (RF) fields are applied to alter the alignment of this magnetization which causes the protons to resonate to produce a weak RF field that is detected, recorded and transformed into detailed images of the scanned area. A large magnetic coil produces the main magnetic field and magnetic field gradient coils apply gradient magnetic fields for spatially encoding the resonance RF signal. Additionally, the patient is positioned at a predetermined location within an imaging region of the magnetic coil to allow the magnetic resonance examination system to produce quality images of the patient.

During MRI examinations often physiological sensors are used, mainly to synchronize or adjust the acquisition scheme to the physiological motion of the patient in order to improve image quality. Besides RF-sensors embedded in RF-coils, also video-based systems are common. Also for general observation of the patient's state video technique is used. This applies especially for sedated or anxious patients. In this way the technician can observe the patient and check for motion and/or unease of the patient. Typically this video based systems are fixed in position at one end of the scanner bore. For fMRI applications or entertainment during scanning, mirrors providing an outside view or in bore monitors/displays may be used. Typically those are also fixed in position.

For all these applications, however, a good positioning of the equipment with respect to the patient's position for taking MRI images or monitoring the patient is required.

The application US2016/0161577 discloses a magnetic resonance examination system comprising a set of rails over which receive coils can be moved relative to the field-of-view and within the footprint of the bore.

Further the US patent application US2013/0021034 discloses a magnetic resonance device with a display panel that is moveably disposed in or on the cladding of the magnet bore.

A disadvantage of the state of the art systems is that equipment which is not needed remains inside the bore of the magnet and further reduces the amount of space available. An easy way to remove unneeded equipment from the bore of the magnet and store it until the next use without manual intervention is not known from the state of the art. In addition, the state of the art systems do not guarantee easy installation of the equipment.

### SUMMARY OF THE INVENTION

It is an object of the invention to provide a solution for proper positioning of auxiliary equipment inside a bore of a magnet of a magnetic resonance examination system when in use, and outside of the bore of the magnet and therefore outside of the examination zone when idle.

This object is achieved by a magnetic resonance examination system comprising an examination zone to position a subject of interest within, a magnet to apply a static magnetic field in the examination zone, wherein the magnet is a cylindrical shaped magnet with a bore around a center axis in which the examination zone is located, at least one carrier for transporting auxiliary equipment, the carrier mounted movable within the magnet parallel to the center axis of the magnet, for freely moving the auxiliary equipment into the examination zone and the carrier being arranged to be moved outside of the bore of the magnet, for freely moving the auxiliary equipment out of the bore of the magnet, the carrier further being arranged such to position the auxiliary equipment mounted to the carrier in the examination zone when the auxiliary equipment is needed and to position the auxiliary equipment mounted to the carrier outside of the examination zone when the auxiliary equipment is not needed.

This object is further achieved by a method for operating a magnetic resonance examination system.

This object is still further achieved by a non-transitory computer-readable medium for controlling a magnetic resonance examination system and by a non-transitory computer-readable medium for upgrading a magnetic resonance imaging system.

The invention allows the use of the carrier to move unneeded equipment outside the examination zone of the magnetic resonance examination system to create more space in the examination zone and ensure easier installation of the equipment.

Preferably the magnetic resonance examination system comprises at least one parking position for the carrier outside the bore of the magnet. A parking position for the carrier outside the bore of the magnet is advantageous to be able to move the auxiliary equipment quickly and easily, without doing manual work, back into the bore of the magnet.

According to a preferred embodiment of the invention the carrier comprises an actuator for influencing the position of the auxiliary equipment mounted to the carrier.

According to a preferred embodiment the magnetic resonance examination system comprises a rail system for guiding the carrier.

Preferably, said rail system is disposed in or on a cladding of the magnet.

According to another preferred embodiment of the invention the auxiliary equipment comprises a patient monitoring arrangement mounted to the carrier.

Preferably, said patient monitoring arrangement comprises at least a physiological sensor, a camera, a LIDAR-sensor, an active RF-device for motion detection and/or a pilot tone RF device. In particular the camera can be also an infrared camera. Additionally said interactive patient monitoring can be a touchpad or interactive device for patient and operator or a touchless sensor (based on 3D Radar using gesture detection) or ultrasound (US). Patient monitoring can also be simply some LED lights. Additionally auxiliary equipment can be an interventional device (needle, ablation device, sedation device) alone or in combination with the the devices shown above.

According to another preferred embodiment of the invention the auxiliary equipment comprises a device for in-bore entertainment or an interactive mirror display.

The present invention also provides a method for operating a magnetic resonance examination system comprising the steps of: moving the auxiliary equipment mounted to the carrier in the examination zone when the auxiliary equipment is needed and moving the auxiliary equipment mounted to the carrier outside of the examination zone when the auxiliary equipment is not needed.

According to a preferred embodiement of the invention the movement of the auxiliary equipment mounted to the carrier is done automatically based on a trigger event.

According to another preferred embodiment of the invention the magnetic resonance examination system comprises a patient monitoring arrangement wherein the trigger event is based on a vital sign of a patient to be examined.

According to a preferred embodiement of the invention the method comprises the additional step of: adapting an imaging protocol or acquisition sequence parameters of the magnetic resonance examination system automatically based on the vital sign of the patient. The imaging protocol can be adapted based on individual patient, which is analysed in the system but also during an imaging sequence if patient is moved trough the bore or the patient moves in the bore.

According to another preferred embodiment of the invention the moving of the auxiliary equipment mounted to the carrier is done relative to a moving of a patient.

The present invention also provides a non-transitory computer-readable medium for controlling a magnetic resonance examination system the non-transitory computer-readable medium comprising instructions stored thereon, that when executed on a processor, perform the method steps according as described above.

The present invention also provides also a non-transitory computer-readable medium for upgrading a magnetic resonance imaging system, whereby the non-transitory computer-readable medium contains instructions for controlling the magnetic resonance imaging system as described above.

### BRIEF DESCRIPTION OF THE DRAWINGS

These and other aspects of the invention will be apparent from and elucidated with reference to the embodiments described hereinafter.

In the drawings:
Fig. 1 is a schematic diagram of a coil arrangement of a magnetic resonance (MR) examination system in accordance with an embodiment of the invention,
Fig. 2 is a schematic diagram of different parking slots in accordance with an embodiment of the invention,
Fig. 3 is a block diagramm of a workflow concept for a magnetic resonance examination system with a carrier for transporting auxiliary equipment in accordance with an embodiment of the invention,
Fig. 4 is a flowchart of a method in accordance with various embodiments of the invention.

### DETAILED DESCRIPTION OF EMBODIMENTS

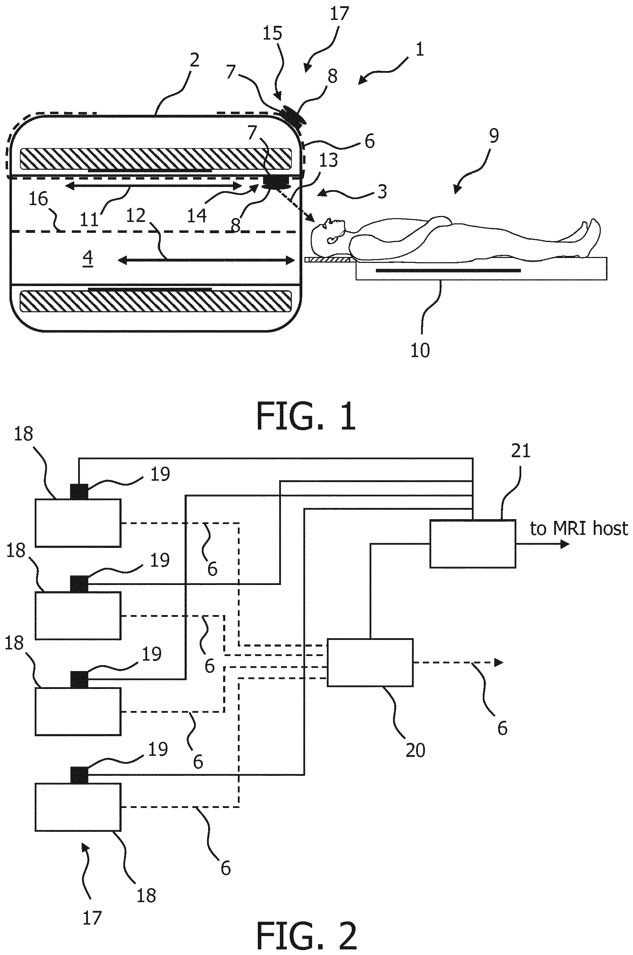

In Fig. 1 a schematic diagram of a coil arrangement of a magnetic resonance examination system 1 in accordance with an embodiment of the invention is shown. A magnetic resonance examination system 1 utilizes magnetic resonance to image a region of interest (ROI) of a patient 9. The system includes a scanner defining an examination zone 4 to accommodate the ROI. The scanner includes a main magnet 2 that creates a strong, static Bo magnetic field extending through the imaging volume. The main magnet 2 typically employs superconducting coils to create the static Bo magnetic field. The magnet 2 shown in Fig. 1 is a cylindrical shaped magnet 2 with a bore 3 around a center axis 16 in which the examination zone 4 is located. A patient support 10 can be employed to support the patient 9 in the scanner and facilitates positioning the ROI in the examination zone 4.

The magnetic resonance examination system 1 further comprises a carrier 7 for transporting auxiliary equipment into the examination zone 4. The carrier 7 is mounted movable within the magnet 2 parallel to the center axis 16 of the magnet 2, for freely moving the auxiliary equipment 8 into the examination zone 4 when the auxiliary equipment 8 mounted to the carrier 7 is needed in the examination zone. Further the carrier 7 is arranged such to be moved outside of the bore 3 of the magnet 2, for freely moving the auxiliary equipment 8 out of the bore 3 of the magnet 2 when the auxiliary equipment 8 mounted to the carrier 7 is not needed in the examination zone 4. This is advantageous to make the auxiliary equipment 8 easier to install on the carrier 7. In an embodiment of the invention a rail system 6 for guiding the carrier 7 can be foreseen, wherein the rail system 6 can be disposed in or on a cladding of the magnet 2.

Fig. 1 shows the carrier 7 with the auxiliary equipment 8 attached to the carrier 7 in two different positions 14, 15. On the one hand the carrier 7 is shown inside 14 the examination zone 4 and on the other hand the carrier 7 is shown outside 15 the examination zone 4 in a certain parking position 17. A parking position 17 for the carrier 7 is useful, for example to simplify the change of the auxiliary equipment 8 mounted to the carrier 7. Also several carriers 7 with different types of auxiliary equipment 8 can be foreseen, which wait in different parking positions 17 for their employment in the examination zone 4. This has the particular advantage that the operating personnel do not have to enter the examination room to change the auxiliary equipment 8.

In an embodiment of the invention different devices can be connected to the carrier 7. For example, the use of a patient monitoring arrangement with the carrier 7 may be provided. The patient monitor arrangement can include the following sensors, for example, vital signs sensors for detecting vital signs e.g. cardiac motion or breathing of the patient like physiological sensors, cameras e.g. video cameras or infrared cameras, LIDAR sensors, an active RF-device for motion detection and/or a pilot tone RF device, key pad, touch pad, wireless sensor, a start stop device for the patient to start and stop the sequence e.g. when the patient is ready or the patient needs a pause due to discomfort. The imaging protocol can be adapted based on an individual patient 9, which is analysed in the system but also during an imaging sequence if the patient 9 is moved trough the bore 3 or the patient 9 moves in the bore 3. In case the patient 9 feels discomfort (vital sign), the patient 9 can himself interact with the scanner via an interactive display, which is positioned at the right place for the patient to be reached. The MRI sequence can also be real time adapted.

The rail transport system 6 as seen in Fig. 1 is integrated or located in the bore of the magnet 2 and partly also outside the bore. The vital signs sensors or devices can translate or move to different positions for optimal signal detection. During travel to scan the camera position can be moved relative to the patient 9 and the field of view keeps constant during movement. The vital signs sensors or devices placement can be adapted to the workflow so that the optimal position for vital signs detection can be tracked. For example, if a camera is used, it may be additionally provided that camera position can be altered to optimize the sensed signal. For this reason the carrier 7 comprises e.g. an actuator for influencing the position of the auxiliary equipment 8 mounted to the carrier 7. For example, the carrier is equipped with a gimbal to optimize for best sensed signal. The mechanical translation of the carriers 7 via the rail system 6 can be done by using a nonmagnetic gear motor/actuator or a bowden cable.

In another embodiment of the invention, it may be intended that the carrier 7 is connected to an AI-based algorithm, wherein the AI-based algorithm detects the position of the patient 9 and automatically orientates e.g. a camera or when the patient is moved in or out of the bore 3 of the magnet 2, the carrier 7 automatically moves or tracks relative to the patient 9. The sensor mounted to the carrier 7 automatically detects the patient 9 outline or optimal surface to detect vital signs e.g. cardiac motion or breathing of the patient.

In another embodiment of the invention e.g. for fMRI applications or entertainment during scanning, mirrors providing an outside view or in bore monitors or displays may be used and mounted to the carrier 7. Typically those are also fixed in position.

In addition, it may be provided that the carrier 7 is used in a therapy system e.g. in a MR-LINAC or a MR-PET for optimal placing e.g. dosimeters, sensors or radiation sources.

Fig. 2 shows a schematic diagram of different parking slots in accordance with an embodiment of the invention. The parking position 17 can hold and provide space for multiple carriers 7 or devices. Each carrier 7 or device is stored locally at a certain parking slot 18. Each parking slot 18 can be equipped with a brake device and sensor functionality 19. Each individual device is preferably a wireless device, which need to be recharged in the parking position 17. Thus a local power management system controls the charging status of the local devices and the functionality and calibration status of the devices. The individual data of the devices are stored and transmitted to a remote service host 21 with a local processor to detect and analyse the functionality of the different devices. A selector actuator 20 selects the corresponding parking slot 18, which is requested by the local processor of the remote service host 21. A software controls the status of the selector 20 and is connected via optical fiber or wireless to the MRI host. The mechanical translation of the individual carriers 7 or devices via the rail system 6 can be done by using a nonmagnetic gear motor/actuator or a bowden cable.

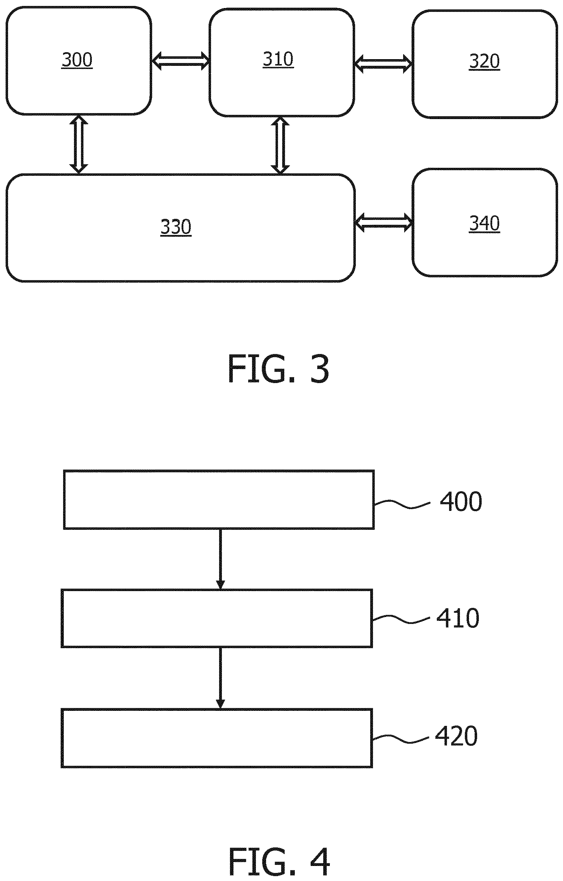

Fig. 3 shows a block diagramm of a workflow concept for a magnetic resonance examination system 1 with a carrier 7 for transporting auxiliary equipment 8 in accordance with an embodiment of the invention. The workflow concept may include various components, thereby allowing the magnetic resonance examination system 1 to perform various processes.

In an example of the invention, the magnetic resonance examination system 1 comprises a transport support module 300, where the transport support module 300 is set up to control the movement of the carrier 7, for example along a rail system 6 inside and outside the bore 3 of a magnet 2. Furthermore, the transport support module 300 can be used to control an actuator of the carrier 7. The actuator serves in particular to influence the position of the auxiliary equipment 8 mounted to the carrier 7. For example, cameras attached to the carrier 7 can be rotated and aligned to a specific point.

The signals for the control of the carrier 7 can come from a local digital processing module 230 or from a patient monitoring arrangement 310, for example from vital signs sensors. The patient monitoring arrangement 310 can also be used to control the patient table 220.

According to an embodiment of the invention, the patient monitoring arrangement 310 includes a machine learning algorithm to derive the patient's sensitive area (e.g. freely visible parts of skin) from the vital signs data. The machine learning provides automatic adaptation of the imaging protocol 340 or acquisition sequence parameters as well as feedback to the operator and the patient to be examined. When the patient 9 is moved inside or outside the bore 3 of the magnet 2, the sensor automatically moves or tracks relative to the patient 9. The sensor automatically detects the patient 9 outline or optimal surface to detect vital signs e.g. cardiac motion or breathing. The embodiment enables the adaption of the imaging protocol or acquisition parameters in real-time which reduces the occurrence of unsuccessful scans. This avoids the need to re-scan an improves patient comfort.

In another embodiment of the invention the arrangement and the workflow concept can be used for proper patient positioning for imaging and monitoring. For example magnetic resonance data can be used to calculate the best patient position for monitoring and a drive path along which the patient is moved. Additional the position data of the patient 9 can be combined with a (3D) camera video and/or a 3D radar for double-check or additional info on patient behavior and/or compliance.

Fig. 4 is a flowchart of a method for operating a magnetic resonance examination 1 system as described in Fig. 1, 2 or 3 in accordance with various embodiments. The method starts with step 400 and comprises the steps of moving the auxiliary equipment 8 mounted to the carrier 7 in the examination zone 4 when the auxiliary equipment 8 is needed and moving the auxiliary equipment 8 mounted to the carrier 7 outside of the examination zone 2 when the auxiliary equipment 8 is not needed. In an embodiment of the invention the moving of the auxiliary equipment 8 mounted to the carrier 7 can be done relative to a moving of a patient 9. By allowing the carrier 7 with the auxiliary equipment 8 mounted to the carrier 7 to move freely e.g. along a rail system 6 within the examination zone 4, an optimal position for the devices can be achieved. In addition e.g. detectors for vital sign detection, RF components, mirrors or entertainment devices can be easly mounted to the carrier 7 when the carrier 7 is moved out of the bore 3 of the magnet 2.

As an additional step 410, it may be provided that the movement of the auxiliary equipment 8 mounted to the carrier 7 is done automatically based on a trigger event. For example when the magnetic resonance examination system 1 comprises a patient monitoring arrangement the trigger event can be based on a vital sign of the patient 9 to be examined. Therefore the proposed method allows the selection of optimal and most suitable position or view for vital signs detection e.g. motion of the patient 9, cardiac motion or breathing

In step 420 an imaging protocol or acquisition sequence parameters of the magnetic resonance examination system 1 is adapted automatically based on the vital signs of the patient 9. The imaging protocol can be adapted based on an individual patient 9, which is analysed in the system but also during an imaging sequence if the patient 9 is moved trough the bore 3 or the patient 9 moves in the bore 3. In case the patient 9 feels discomfort (vital sign), the patient 9 can himself interact with the scanner via an interactive display, which is positioned at the right place for the patient to be reached. The MRI sequence can also be real time adapted.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### REFERENCE SYMBOL LIST:

1 magnetic resonance examination system
2 MRI magnet
3 bore of the MRI magnet
4 examination zone
6 rail system
7 carrier
8 auxiliary equipment
9 patient
10 patient table
11 direction of movement of the carrier
12 direction of movement of the patient
13 tracking of the patient
14 carrier with auxiliary equipment inside of the bore
15 carrier with auxiliary equipment outside of the bore
16 center axis
17 parking position
18 parking slot
19 sensor
20 selector actuator
21 remote service host
300 transport support module
310 patient monitor arrangement
320 MR table
330 local digital signal processing module
340 MRI sequence
400 moving the auxiliary equipment in the examination zone or out of the examination zone
410 moving the auxiliary equipment automatically based on a trigger event
420 adapting an imaging protocol or acquisition sequence parameters of the magnetic resonance examination system

## Claims

1. A magnetic resonance examination system (1) comprising
an examination zone (4) to position a subject of interest (9) within,
a magnet (2) to apply a static magnetic field in the examination zone (4), wherein the magnet (2) is a cylindrical shaped magnet with a bore (3) around a center axis (16) in which the examination zone (2) is located,
at least one carrier (7) for transporting auxiliary equipment (8), the carrier (7) mounted movable within the magnet (2) parallel to the center axis (16) of the magnet (2), for freely moving the auxiliary equipment (8) into the examination zone (4) and the carrier (7) being arranged to be moved outside of the bore (3) of the magnet (2), for freely moving the auxiliary equipment (8) out of the bore (3) of the magnet (2), the carrier (7) further being arranged such to position the auxiliary equipment (8) mounted to the carrier (7) in the examination zone (4) when the auxiliary equipment (8) is needed and to position the auxiliary equipment (8) mounted to the carrier (7) outside of the examination zone (4) when the auxiliary equipment (8) is not needed.

2. A magnetic resonance examination system (1) according to claim 1, wherein the magnetic resonance examination system (1) comprises at least one parking position (17) for the carrier (7) outside the bore of the magnet (2).

3. A magnetic resonance examination (1) system according to any one of the preceding claims, wherein the carrier (7) comprises an actuator for influencing the position of the auxiliary equipment (8) mounted to the carrier (7).

4. A magnetic resonance examination (1) system according to any one of the preceding claims, wherein the magnetic resonance examination system (1) comprises a rail system (6) for guiding the carrier (7).

5. A magnetic resonance examination system (1) according according to claim 4 wherein the rail system (6) is disposed in or on a cladding of the magnet (2).

6. A magnetic resonance examination system (1) according to any one of the preceding claims, wherein the auxiliary equipment (8) comprises a patient monitoring arrangement mounted to the carrier (7).

7. A magnetic resonance examination system (1) according to claim 6, wherein the patient monitoring arrangement comprises at least a physiological sensor, a camera, a LIDAR-sensor, an active RF-device for motion detection and/or a pilot tone RF device.

8. A method for operating a magnetic resonance examination (1) system according to any one of claims 1 to 6 comprising the steps of:
moving the carrier (7) in the examination zone (4) when the auxiliary equipment (8) is needed and
moving the carrier (7) outside of the examination zone (2) when the auxiliary equipment (8) is not needed.

9. A method for operating a magnetic resonance examination system (1) according to claim 8, wherein the step of moving the carrier (7) outside of the examination zone (2) when the auxiliary equipment (8) is not needed comprises the step of moving the carrier (7) in a parking position (17) outside the bore (3) of the magnet (2).

10. A method for operating a magnetic resonance examination system (1) according to according to any one of claims 8 to 9, wherein the movement of the auxiliary equipment (8) mounted to the carrier (7) is done automatically based on a trigger event.

11. A method for operating a magnetic resonance examination system (1) according to claim 10, wherein the magnetic resonance examination system (1) comprises a patient monitoring arrangement wherein the trigger event is based on a vital sign of a patient (9) to be examined.

12. A method for operating a magnetic resonance examination system (1) according to claim 11 comprising the additional step of:
adapting an imaging protocol or acquisition sequence parameters of the magnetic resonance examination system (1) automatically based on the vital sign of the patient (9).

13. A method for operating a magnetic resonance examination system (1) according to any one of claims 8 to 12, wherein the moving of the auxiliary equipment (8) mounted to the carrier (7) is done relative to a moving of a patient (9).

14. A non-transitory computer-readable medium for controlling a magnetic resonance examination system (1) the non-transitory computer-readable medium comprising instructions stored thereon, that when executed on a processor, perform the method steps according to any one of claims 8 to 12.

15. A non-transitory computer-readable medium for upgrading a magnetic resonance imaging system (1), whereby the non-transitory computer-readable medium contains instructions for controlling the magnetic resonance imaging system (1) according to any one of claims 8 to 12.
